# EUROPEAN PATENT SPECIFICATION

(11) **EP 3 522 205 B1**
(45) Date of publication and mention of the grant of the patent: **06.08.2025**
(21) Application number: 16917660.9
(22) Date of filing: 28.09.2016
(51) Int. Cl.: H01L 21/52, H01L 21/67

(54) **DIE MOUNTING APPARATUS**
VORRICHTUNG ZUR CHIPMONTAGE
APPAREIL DE MONTAGE DE PUCES

(43) Date of publication of application: 07.08.2019
(73) Proprietor: Fuji Corporation, Chiryu-shi, Aichi 472-8686 (JP)
(72) Inventor: KAWAGUCHI, Koji, Chiryu, Aichi (JP); ICHIKAWA, Shigeto, Chiryu, Aichi (JP)
(74) Representative: Grünecker Patent- und Rechtsanwälte PartG mbB
(86) International application number: PCT/JP2016/078618
(87) International publication number: WO 2018/061107

(56) References cited:
- WO-A1-2014/155535
- JP-A- 2013 065 732
- JP-A- 2015 029 124
- JP-A- H0 766 269
- JP-A- H02 246 233
- US-A1- 2012 329 182
- US-A1- 2013 071 956
- US-A1- 2014 208 850
- US-A1- 2015 096 651
- US-A1- 2016 037 694

## Description

### Technical Field

The present invention relates to a die mounting device.

### Background Art

Conventionally, there is a known component mounting device provided with a load cell between a suction nozzle and a linear motor that lowers the suction nozzle, and that determines that a component was damaged when a counterforce detected by the load cell decreases rapidly when the suction nozzle contacts the component during pickup or when the component held by the suction nozzle contacts a mounting target (for example, refer to patent literature 1).

Patent literature 2 and Patent literature 3 provide further die mounting devices according to the prior art.

### Citation List

### Patent Literature

Patent literature 1: WO2014/155535A1
Patent literature 2: US 2014208850 A1
Patent literature 3: JP 2015 029124 A

### Summary of Invention

### Technical Problem

With patent literature 1 above, although it is disclosed to determine whether a component was damaged based on a counterforce detected by a load cell when picking up a thin component with a suction nozzle, there is no disclosure of determining whether a die has broken when peeling the die from a sheet to which a wafer divided into multiple dies is affixed.

An object of the present invention is to appropriately determine whether a die has broken when peeling the die from a sheet to which a wafer divided into multiple dies is affixed. Solution to Problem

The present invention uses the following means to achieve the above object.

A die mounting device of the present invention is a die mounting device configured to pick up a die from a sheet to which a wafer divided into multiple dies is affixed using a nozzle and mount the die on a target object, the die mounting device including: a board conveyance device for loading and fixing the target object at a mounting position, a tape supply device comprising a reel around which a tape for supplying components to the mounting device is wound; a head including the nozzle configured to be raised and lowered and to pick up die from the sheet or a component supplied from tape supply device; a peeling device configured to peel the die from the sheet by pushing the die to be picked up by the nozzle from underneath the sheet using a pusher pin; a component camera provided between the board conveyance device and the tape supply device and configured to image a die held by suction nozzle when suction nozzle holding the die passes above component camera and to output the image to the control device; a load measuring section configured to measure a load applied to the nozzle or the pusher pin; and a control section configured to control the head and the peeling device such that the die is picked up by the nozzle by being peeled from the sheet with the pusher pin pushing the die from underneath the sheet in a state with the nozzle contacting the die, and determine whether the die has broken based on the load measured by the load measuring section when the die is pushed up by the pusher pin wherein the control device is configured to, when determining that the die has broken, control the mounting head to pick up the die using the nozzle and discard the die to a specified discard location remote of the peeling device on a path that avoids going above component camera and target object.

A die mounting device of the present invention is configured to pick up a die from a sheet to which a wafer divided into multiple dies is affixed using a nozzle and mount the die on a target object, and is provided with a head, a peeling device, a load measuring section, and a control section. The control device controls the head and the peeling device such that the die is picked up by the nozzle by being peeled from the sheet with the pusher pin pushing the die from underneath the sheet in a state with the nozzle contacting the die, and determines whether the die has broken based on the load measured by the load measuring section when the die is pushed up by the pusher pin. Thus, it is possible to quickly and appropriately determine if a die has broken when being picked up from the wafer. Thin dies affixed to a sheet break easily because they bend when pushed by the pusher pin. If such a die breaks, tiny fragments are created that may have a negative effect on surrounding dies. Therefore, with the die mounting device, by quickly determining whether a die has broken, appropriate measures can be taken and any negative effects are minimized.

In a die mounting device which does not form part of the present invention, the control device may be configured to, when determining that the die has broken, control the mounting head to return the die to its original position on the sheet. With a die mounting device of the present invention, the control device is configured to, when determining that the die has broken, control the
mounting head to pick up the die using the nozzle and discard the die to a specified discard location. This prevents fragments created by the die breaking from falling onto a target object or the like.

Also, with a die mounting device of the present invention, the control device may be configured to control the peeling device and the head such that the die is peeled from the sheet by the peeling device and picked up by the nozzle based on the load measured by the load measuring section, or control the head such that the die picked up by the nozzle is mounted on the target object based on the load measured by the load measuring section. In this manner, the die mounting device does not have to be provided with a dedicated load measuring section to determine whether the die has broken.

### Brief Description of Drawings

Fig. 1

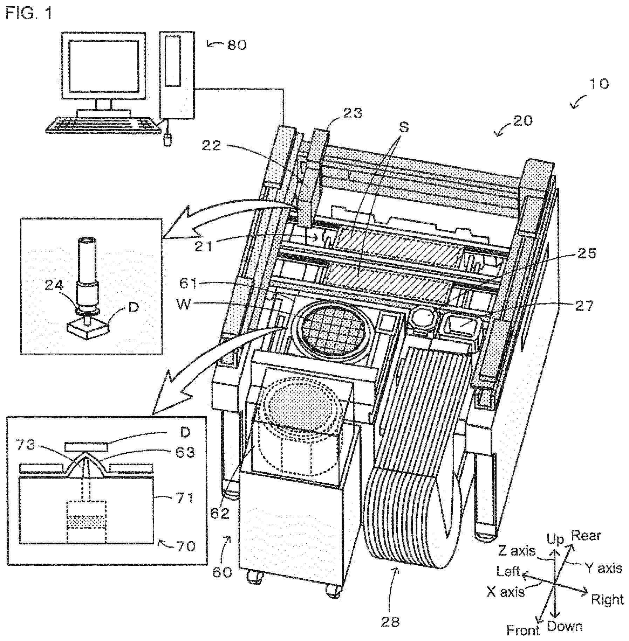

   Fig. 1 shows the overall configuration of component mounting system 10.
Fig. 2

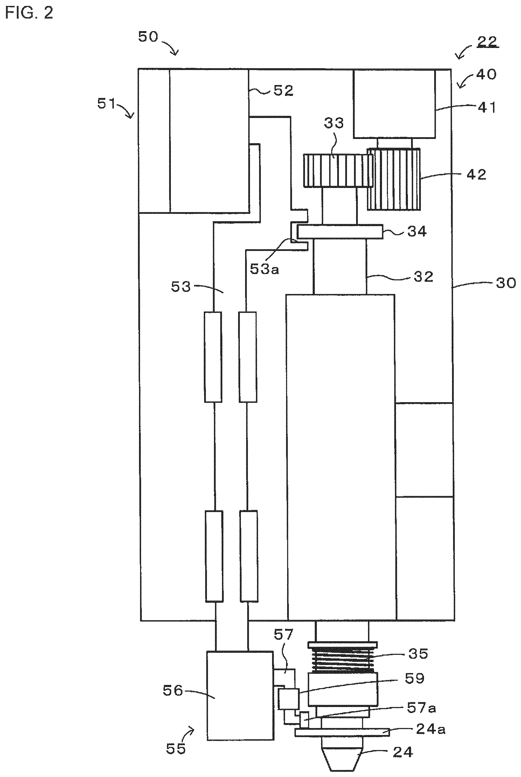

   Fig. 2 shows the overall configuration of mounting head 22.
Fig. 3

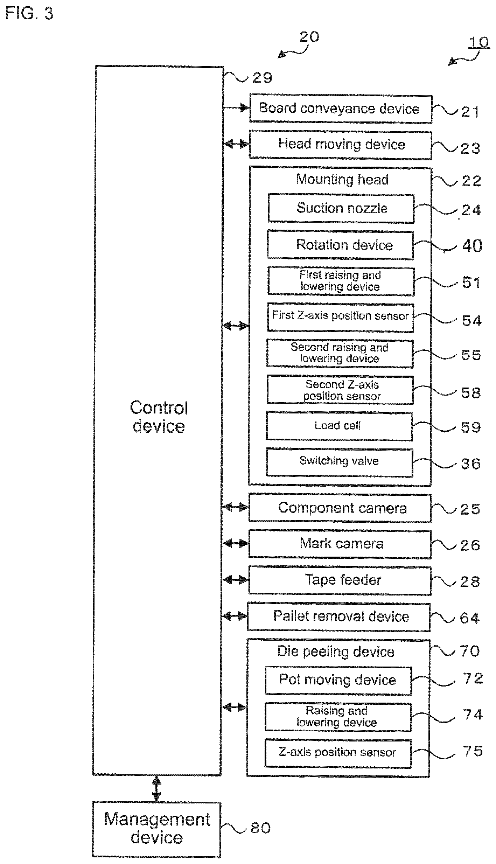

   Fig. 3 is a block diagram showing electrical connections of mounting system 10.
Fig. 4

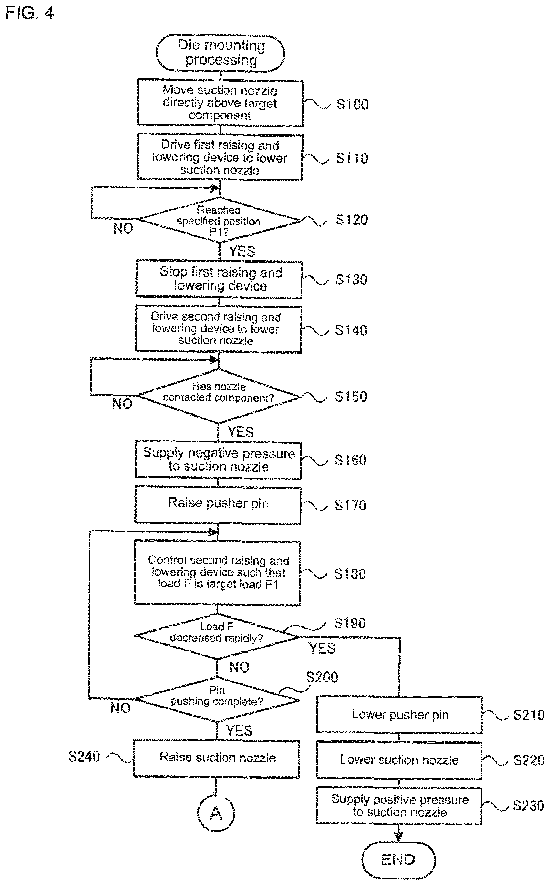

   Fig. 4 is a flowchart showing an example of die mounting processing (former portion), which is not an embodiment of the present invention.
Fig. 5

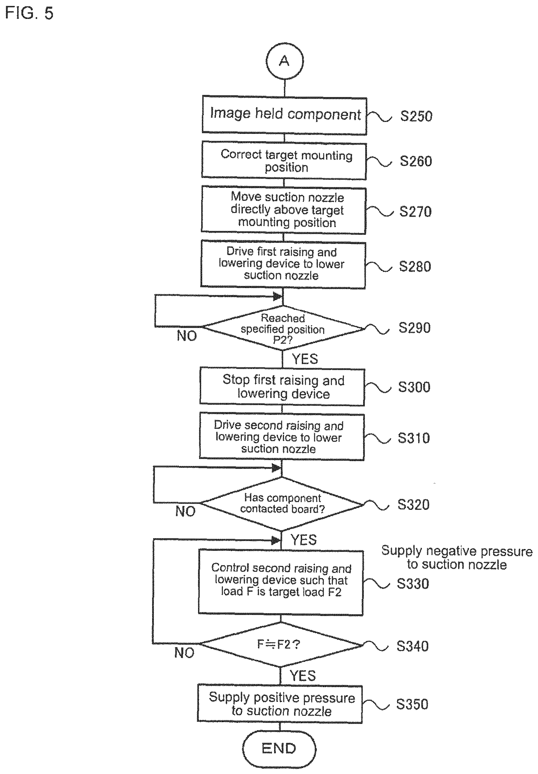

   Fig. 5 is a flowchart showing an example of die mounting processing (latter portion).
Fig. 6

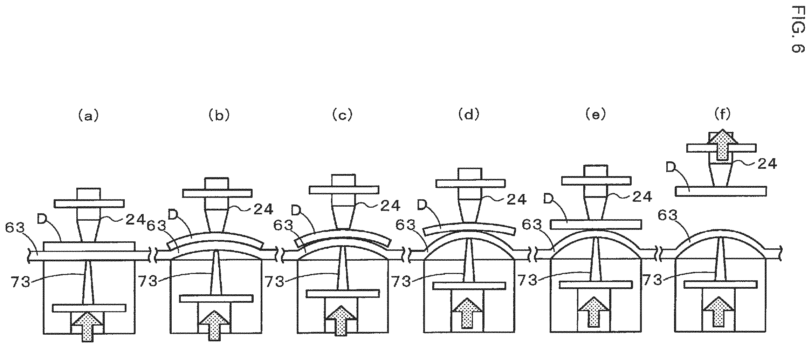

   Fig. 6 illustrates states during pickup by suction nozzle 24 of die D affixed to die sheet 63.
Fig. 7

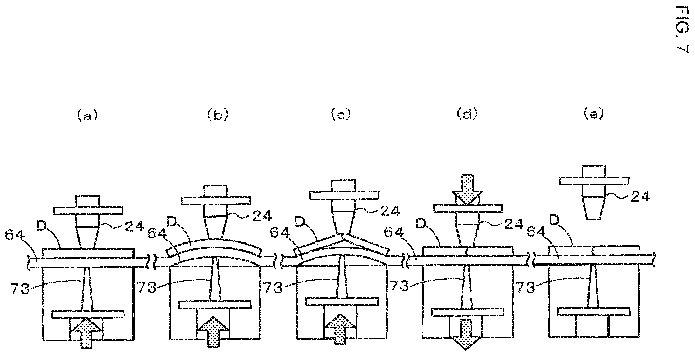

   Fig. 7 illustrates states of a countermeasure when die D being picked up by suction nozzle 24 breaks that is not an embodiment of the present invetion.
Fig. 8

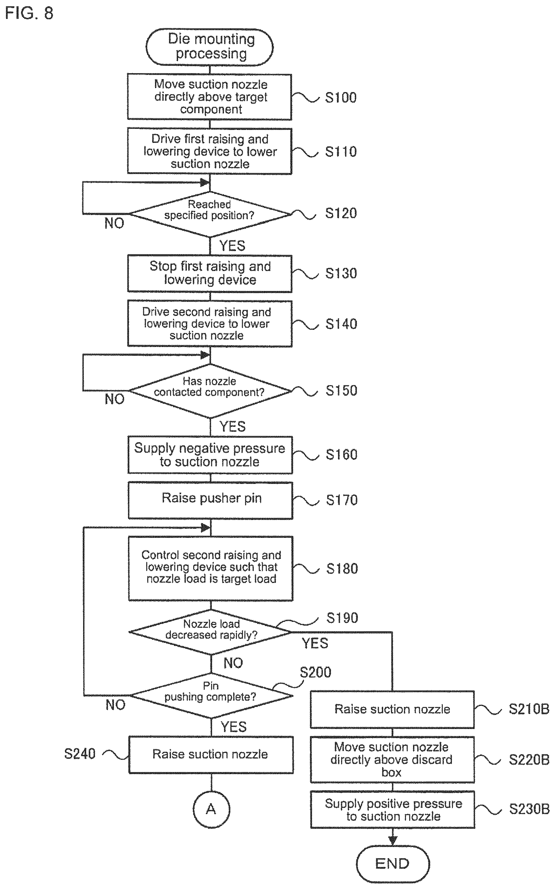

   Fig. 8 is a flowchart showing die mounting processing (former portion) of an embodiment of the present invention.
Fig. 9

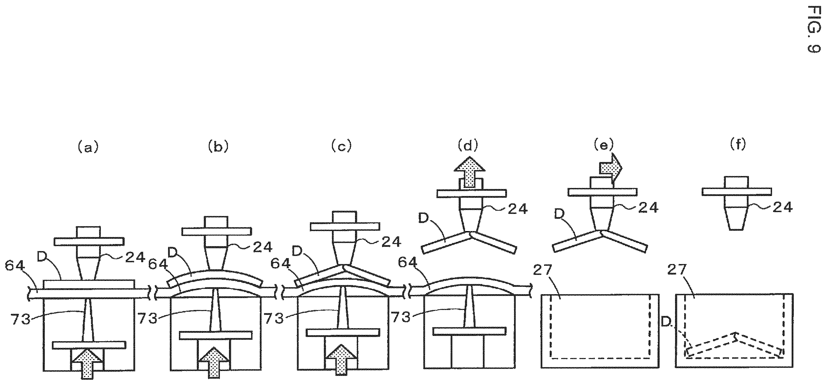

   Fig. 9 illustrates states of a countermeasure when a component being picked up by suction nozzle 24 breaks, in accordance with embodiments of the present invention.

### Description of Embodiments

Embodiments of the present invention are described below with reference to the figures.

Fig. 1 shows the overall configuration of component mounting system 10; fig. 2 shows the overall configuration of mounting head 22; fig. 3 is a block diagram showing electrical connections of mounting system 10. Note that, in fig. 1, the left-right direction is the X-axis direction, the front-rear direction is the Y-axis direction, and the up-down direction is the Z-axis direction.

As shown in fig. 1, component mounting system 10 is a system for mounting a component such as dies D divided on wafer W onto a target object (board S, another component, or the like), and is provided with component mounting device 20 and management computer (PC) 80. In component mounting system 10, multiple component mounting devices 20 that mount components on board S are arranged in a line from upstream to downstream. For convenience of description, fig. 1 only shows one component mounting device 20. Note that, component mounting system 10 may also be provided with items such as a solder printer, inspection machine, and reflow oven in the same mounting line as component mounting device 20.

Component mounting device 20 is provided with board conveyance device 21, mounting head 22, head moving device 23, suction nozzle 24, component camera 25, mark camera 26, discard box 27, tape supply device 28, wafer supply device 60, and control device 29. Board conveyance device 21 loads board S, conveys board S, fixes board S at a mounting position, and unloads board S. Board conveyance device 21 includes a pair of conveyor belts provided extending in a left-right direction and separated in the front-rear direction of fig. 1. Board S is conveyed by these conveyor belts.

Mounting head 22 is for picking up die D supplied from wafer supply device 60 or a component supplied from tape supply device 28 and mounting it on board S fixed by board conveyance device 21, and is moved in XY-axis directions by head moving device 23. Head moving device 23 is provided with sliders loaded on guide rails so as to slide in XY-axis directions, motors for driving the sliders, and position sensors for detecting the position of the sliders in the XY-axis directions.

As shown in fig. 2, mounting head 22 is provided with head main body 30, suction nozzle 24, rotation device 40, and raising and lowering device 50. At least one nozzle holder 32 is attached to mounting head 22 and suction nozzle 24 is removably attached to the lower end of nozzle holder 32. Suction nozzle 24 is attached to be movable in an up-down direction (Z-axis direction) with respect to nozzle holder 32. A compression spring, not shown, is built into nozzle holder 32 and suction nozzle 24 is biased upwards with respect to nozzle holder 32 by the biasing force of the compression spring. Rotation device 40 is provided with rotation motor 41 with gear 42 provided on rotation shaft thereof, and a rotation position sensor for detecting the rotation position of rotation motor 41. Gear 33 that engages with gear 42 is provided on the top end of nozzle holder 32, and nozzle holder 32 is movable in the Z-axis direction with respect to gear 42. Mounting head 22 can freely adjust the angle of nozzle holder 32 by driving rotation motor 41. Suction nozzle 24 is attached to nozzle holder 32, and mounting head 22 can adjust the angle of a component held by suction nozzle 24 by adjusting the angle of nozzle holder 32.

Raising and lowering device 50 is provided with first raising and lowering device 51, second raising and lowering device 55, and load cell 59 (load measuring section). First raising and lowering device 51 is provided with first linear motor 52, first Z-axis slider 53 capable being raised and lowered in the Z-axis direction by the driving of first linear motor 52, and first Z-axis position sensor 54 that detects the position of first Z-axis slider 53 in the Z-axis direction. First engaging section 53a that can engage with (contact) horizontal section 34 provided on nozzle holder 32 is formed on first Z-axis slider 53. Therefore, suction nozzle 24 attached to nozzle holder 32 can be raised and lowered in accordance with the raising and lowering of first Z-axis slider 53.

Second raising and lowering device 55 is provided with second linear motor 56 attached to first Z-axis slider 53 of first raising and lowering device 51, and second Z-axis slider 57 that can be raised and lowered by the driving of second linear motor 56. Second engaging section 57a that can engage with (contact) an upper surface of flange section 24a that extends in a diameter direction at an upper section of suction nozzle 24 is formed on second Z-axis slider 57. Therefore, suction nozzle 24 can be raised and lowered in accordance with the raising and lowering of second Z-axis slider 57. In the present embodiment, the stroke distance of second Z-axis slider 57 by second raising and lowering device 55 is shorter than the stroke distance of first Z-axis slider 53 by first raising and lowering device 51. Raising and lowering device 50, after roughly adjusting the Z-axis position of suction nozzle 24 using first raising and lowering device 51, finely adjusts the Z-axis position of suction nozzle 24 using second raising and lowering device 55. Also, load cell 59 for detecting load F applied to suction nozzle 24 when suction nozzle 24 picks up a component is provided on second Z-axis slider 57.

The suction opening of suction nozzle 24 is connected to a negative pressure source and a positive pressure source via switching valve 36 (electromagnetic valve), and by driving switching valve 36 a component is picked up by negative pressure being supplied to the suction opening and the component is released by applying positive pressure to the suction opening.

Component camera 25 is provided between board conveyance device 21 and tape supply device 28. Component camera 25 images a component held by suction nozzle 24 when suction nozzle 24 holding the component passes above component camera 25, and outputs the image to control device 29.

Mark camera 26 is provided on head moving device 23 to be movable in XY-axis directions. Mark camera 26 images from above positioning reference marks provided on board S for recognizing the position of board S as it is conveyed, and outputs an image of the reference marks to control device 29. Also, mark camera 26 images from above wafer W that includes dies D to be picked up by mounting head 22, and sends the image to control device 29.

Discard box 27 is provided between board conveyance device 21 and tape supply device 28. Discard box 27 is a box to which components for which a pickup error or a mounting error occurred are discarded.

Tape supply device 28 is provided with a reel around which tape storing components is wound, and supplies components to component mounting device 20 by pulling the tape from the reel.

Wafer supply device 60 is for supplying dies D divided on wafer W to a pickup position of mounting head 22 and is provided with wafer pallet 61, magazine 62, and die peeling device 70. Die sheet 63 to which wafer W is affixed is attached to wafer pallet 61 in a stretched state. Multiple wafer pallets 61 are stored in magazine 62, and a wafer pallet 61 is pulled out from magazine 62 by pallet removal device 64 when die D is to be picked up by mounting head 22.

Die peeling device 70 is provided with pot 71, pot moving device 72, pusher pin 73 (pushing section), and raising and lowering device 74. Pot 71 is arranged below wafer pallet 61 removed by pallet removal device 64, and is movable in the XY-axis directions via pot moving device 72. Pot moving device 72 is provided with sliders loaded on guide rails so as to slide in XY-axis directions, motors for driving the sliders, and position sensors for detecting the position of the sliders in the XY-axis directions. Pusher pin 73 is arranged inside pot 71 and is for pushing up die D from underneath die sheet 63, the die D being the die D to be picked up among the dies D divided on wafer W affixed to die sheet 63. Multiple types of pusher pins 73 of a different quantity and size are provided in accordance with the size of die D. Die peeling device 70 is provided with multiple pots 71 that include different types of pusher pins 73, and by selecting a pot 71 in accordance with the size of the die D, the die can be pushed. A suction opening is provided on an upper surface of pot 71, and die peeling device 70 is able to push up and peel only the die D to be picked up die sheet 63 by pusher pin 73 pushing up the die in a state with the upper surface of pot 71 suctioning and supporting die sheet 63.

Raising and lowering device 74 is configured to raise and lower pot 71 and pusher pin 73, and when the upper surface of pot 71 approaches a position just about contacting die sheet 63, the raising of pot 71 is stopped by a stopper mechanism, which is not shown, then, pusher pin 73 protrudes from the upper surface of pot 71, and die D is pushed from underneath die sheet 63.

Control device 29 is configured from a microprocessor built around a CPU, and is provided with ROM, RAM, an input and output board, and the like. As shown in fig. 3, control device 29 receives signals from mounting head 22 (first Z position sensor 54, and second Z-axis position sensor 28, load cell 59, and a rotation position sensor), head moving device 23 (position sensor), component camera 25, mark camera 26, tape supply device 28, pallet removal device 64, and die peeling device 70 (Z-axis position sensor 75) via an input port. Also, control device 29 outputs signals to board conveyance device 21, mounting head 22 (first raising and lowering device 51, second raising and lowering device 55, rotation device 40, switching valve 36), component camera 25, mark camera 26, tape supply device 28, pallet removal device 64, and die peeling device 70 (pot moving device 72 and raising and lowering device 74) via an output port.

Management PC 80 is connected to control device 29 such that communication is possible and manages items such as job information. Job information includes, for example, the mounting order of components, the sizes and types of components to be mounted, devices to be used, the size of board S, the production quantity, and so on.

Next, operation of component mounting system 10 of an example that is useful for understanding the invention and is configured as above is described, in particular, operation of picking up a die D from wafer W and mounting the die D on a target object. Figs. 4 and 5 are flowcharts showing an example of die mounting processing performed by control device 29. This processing is performed when a production command including job information is received from management PC 80.

With die mounting processing, control device 29, first, performs drive control of head moving device 23 such that suction nozzle 24 is moved directly above the die D (target die) to be picked up (step S100). Next, control device 29 performs drive control of first raising and lowering device 51 to lower suction nozzle 24 at high speed (step S110). Further, control device 29 determines whether the position of suction nozzle 24 in the Z-axis direction identified based on signals from first Z-axis position sensor 54 and second Z-axis position sensor 58 has reached specified position P1 (step S120). Here, specified position P1 is defined as a position a specified distance before suction nozzle 24 contacts die D.

Control device 29, if determining that the position of suction nozzle 24 has not reached specified position P1, continues lowering suction nozzle 24 using first raising and lowering device 51, and if determining that the position of suction nozzle 24 has reached specified position P1, stops driving first raising and lowering device 51 (step S130) and further lowers suction nozzle 24 at low speed by performing drive control of second raising and lowering device 55 (step S140). Then, control device 29 determines whether suction nozzle 24 has contacted the target die (step S150). This processing, for example, may be performed by determining whether load F applied to suction nozzle 24 that is detected by load cell 59 exceeds a specified load. Control device 29, if determining that suction nozzle 24 has not contacted the target die, continues lowering suction nozzle 24, and if determining that suction nozzle 24 has contacted the target die, performs drive control of switching valve 36 to supply negative pressure to the suction opening of suction nozzle 24 (step S160) and then performs drive control of raising and lowering device 74 of due peeling device 70 to push up the target die from underneath die sheet 63 (step S170). Then, control device 29 continues drive control of second raising and lowering device 55 using feedback control such that load F applied to suction nozzle 24 remains at target load F1 (step S180), determines whether load F decreases rapidly (step S190), then determines whether the pushing of the target die is complete and whether peeling of the target die is complete (step S200). Here, the processing of step S190 is to determine whether the target die has broken due to pushing of the target die by pusher pin 73 and is performed, for example, by determining whether an absolute value of the reduction amount in load F in a given period of time has exceeded a specified amount.

Control device 29, if determining that load F applied to suction nozzle 24 before completion of pushing of the target die by pusher pin 73 has decreased rapidly, determines that the target die has been damaged, then performs drive control of raising and lowering device 74 of die peeling device 70 to lower pusher pin 73 (step S210), and performs drive control of second raising and lowering device 55 to lower suction nozzle 24 (step S220). Then, control device 29 returns the target die to its original position on die sheet 63 by performing drive control of switching valve 36 to supply positive pressure to the suction opening of suction nozzle 24 (step S230), then ends processing.

On the other hand, control device 29, if determining that pushing of the target die by pusher pin 73 is complete without load F applied to suction nozzle 24 decreasing rapidly, performs drive control of first raising and lowering device 51 and second raising and lowering device 55 to raise suction nozzle 24 and pick up the target die (step S240). Next, control device 29 moves the target die held by suction nozzle 24 above component camera 25, captures an image using component camera 25 (step S250), processes the acquired image, and corrects the target mounting position on board S (step 260). Then, control device 29 performs drive control of head moving device 23 to move the target die held by suction nozzle 24 directly above the target mounting position (step S270) and performs drive control of first raising and lowering device 51 to lower suction nozzle 24 at high speed (step S280). Next, control device 29 determines whether the position of suction nozzle 24 in the Z-axis direction has reached specified position P2 (step 290). Here, specified position P2 is defined as a position a specified distance before the target die held by suction nozzle 24 contacts board S. Control device 29, if determining that the position of suction nozzle 24 has not reached specified position P2, continues lowering suction nozzle 24 using first raising and lowering device 51, and if determining that the position of suction nozzle 24 has reached specified position P2, stops driving first raising and lowering device 51 (step S300) and further lowers suction nozzle 24 at low speed by performing drive control of second raising and lowering device 55 (step S310). Then, control device 29 determines whether the target die held by suction nozzle 24 has contacted board S (step S320). This processing, for example, similar to step S150, may be performed by determining whether load F applied to suction nozzle 24 exceeds a specified load. Control device 29, if determining that the target die has not contacted board S, continues lowering suction nozzle 24 using second raising and lowering device 55, and if determining that the target die has contacted board S, performs drive control of second raising and lowering device 55 using feedback control such that load F applied to suction nozzle 24 is target load F2 (step S330), and determines whether load F is substantially equal to target load F2 (step S340). Here, target load F2 is defined as an appropriate pushing load for mounting the target die on board S. Then, control device 29, if determining that load F is substantially equal to target load F2, performs drive control of switching valve 36 to supply positive pressure to the suction opening of suction nozzle 24 such that the target die is mounted on board S (step S350), then ends processing.

Fig. 6 illustrates states during pickup by suction nozzle 24 of die D affixed to die sheet 63. Control device 29 performs drive control of second raising and lowering device 55 of mounting head 22 such that suction nozzle 24 contacts die D, and performs drive control of raising and lowering device 74 of die peeling device 70 such that die D is pushed from underneath die sheet 63 by pusher pin 73 (refer to fig. 6[a]). Control device 29, while die D is being pushed up by pusher pin 73, performs drive control of second raising and lowering device 55 using feedback control such that load F applied to suction nozzle 24 is target load F1, thereby ensuring that an excessive force is not applied to die D (refer to figs. 6[a] to [d]). Next, control device 29, when pushing up by pusher pin 73 has been completed and die D has been peeled from die sheet 63 (refer to fig. 6[e]), suction nozzle 24 is raised and the peeled die D is picked up (refer to fig. 6[f]).

Fig. 7 illustrates states of a countermeasure**,** which is not an embodiment of the present invention, when a component being picked up by suction nozzle 24 breaks. Control device 29, if determining that load F applied to suction nozzle 24 decreased rapidly while die D was being pushed up by pusher pin 73 (refer to figs. 7[a] and [b]), determines that die D broke (refer to fig. 7[c]). In this case, control device 29 performs drive control of raising and lowering device 74 to lower pusher pin 73 and performs drive control of second raising and lowering device 55 to lower suction nozzle 24 so as to return the broken die D to its original position on die sheet 63 (refer to figs. 7[d] and [e]). Thus, by not picking up a broken die D with suction nozzle 24, tiny fragments created by the broken die D do not fall in various locations inside component mounting device 20.

Correspondences between main constituent elements of the embodiments and main constituent elements of the invention will be clarified here. Component mounting device 20 corresponds to a "die mounting device", suction nozzle 24 corresponds to a "nozzle", mounting head 22 corresponds to a "head", die peeling device 70 corresponds to a "peeling device", load cell 59 corresponds to a "load measuring section", and control device 29 corresponds to a "control device".

Component mounting device 20 of an embodiment described above uses suction nozzle 24 to pick up a die D that is a target for pickup from among dies D affixed to die sheet 63 while the die D is being pushed up from underneath die sheet 63 by pusher pin 73. Also, component mounting device 20 is provided with load cell 59 for detecting a load applied to suction nozzle 24, and determines whether die D has broken based on a change in the load F applied to suction nozzle 24 when die D is pushed up by pusher pin 73 in a state with suction nozzle 24 contacting die D. Thus, it is possible to quickly and appropriately determine whether die D has broken using load cell 59.

Further, component mounting device 20, if determining that die D has broken, lowers pusher pin 73 and lowers suction nozzle 24, and supplies positive pressure to the suction opening of suction nozzle 24 such that broken die D is returned to its original position on die sheet 63. Thus, tiny fragments of broken die D do not fall in various locations inside component mounting device 20.

Meanwhile, it goes without saying that the invention is not limited to the above-mentioned embodiments and various embodiments may be applied within the technical scope of the invention.

For example, in a case that is not an embodiment of the present invention, in which die D pushed up by pusher pin 73 breaks, the broken die D is returned to its original position on die sheet 63**.** In accordance with embodiments of the present invention, the broken die D is picked up by suction nozzle 24 and discarded in discard box 27. Fig. 8 is a flowchart showing die mounting processing (former portion) of an alternative embodiment. The latter portion of the die mounting processing of the alternative embodiment is the same as that shown in the flowchart of fig. 5, so a separate flowchart is omitted. Note that, for processing of each step of the die mounting processing of fig. 8 that is the same as the die mounting processing of fig. 4, the same step numbers are used and descriptions are omitted. Also, the latter portion of the die mounting processing of the alternative embodiment is the same as that shown in the flowchart of fig. 5, so a separate flowchart is omitted.

In the die mounting processing of fig. 8, control device 29, if determining that die D has broken because load F applied to suction nozzle 24 has decreased rapidly in step S190, performs drive control of first raising and lowering device 51 and second raising and lowering device 55 such that the broken die D remains held by suction nozzle 24 and suction nozzle 24 is raised (step S210B). Then, control device 29 performs drive control of head moving device 23 such that suction nozzle 24 is moved directly above discard box 27 (step S220B), drops the broken die D held by suction nozzle 24 into discard box 27 by supplying positive pressure to the suction opening of suction nozzle 24 (step S230B), then ends die mounting processing.

Fig. 9 illustrates states of a countermeasure when die D being picked up by suction nozzle 24 breaks. Control device 29, if determining that die D broke while being pushed up by pusher pin 73 (refer to figs. 9[a] and [b]), raises suction nozzle 24 with the broken die D still held by the suction nozzle 24, and performs drive control of head moving device 23 such that suction nozzle 24 is moved directly above discard box 27. Here, control device 29 moves suction nozzle 24 on a path that avoids going above component camera 25 and board S such that fragments of broken die D do not fall on component camera 25 or board S. Also, control device 29 supplies positive pressure to the suction opening of suction nozzle 24 to release die D from suction nozzle 24 and drop it into discard box 26.

In an embodiment above, mounting head 22 is provided with two raising and lowering devices (first raising and lowering device 51 and second raising and lowering device 55), but may be provided with only one raising and lowering device.

In an embodiment above, load cell 59 is provided on mounting head 22 as a load measuring section, but the breaking of die D being picked up may be determined based on the load F applied to suction nozzle 24. Further, a load cell for measuring a load applied to pusher pin 73 may be provided in die peeling device 70 and the breaking of the die D being picked up may be determined based on the load applied to the pusher pin.

In an embodiment above, load cell 59 for measuring load F applied to suction nozzle 24 is provided on mounting head 22, but the load applied to suction nozzle 24 may be measured by detecting or estimating the load current of second linear motor 56.

### Industrial Applicability

The present invention may be applied to, for example, a manufacturing industry of die mounting devices.

### Reference Signs List

10: component mounting system;
20: component mounting device;
21: board conveyance device;
22: mounting head;
23: head moving device;
24: suction nozzle;
24a: flange section;
25: component camera;
26: mark camera;
27: reject box;
28: tape supply device;
30: head main body;
32: nozzle holder;
33: gear;
34: horizontal section;
36: switching valve;
40: rotation device;
41: rotation motor;
42: gear;
50: raising and lowering device;
51: first raising and lowering device;
52: first linear motor;
53: first Z-axis slider;
53a: first engaging section;
54: first Z-axis position sensor;
55: second raising and lowering device;
56: second linear motor;
57: second Z-axis slider;
57a: second engaging section;
58: second Z-axis position sensor;
59: load cell;
60: wafer supply device;
61: wafer pallet;
62: magazine;
63: die sheet;
64: pallet removal device;
70: die peeling device;
71: pot;
72: pot moving device;
73: pusher pin;
74: raising and lowering device;
75: Z-axis position sensor;
80: management computer (PC);
P: component;
S: board;
W: wafer

## Claims

1. A die mounting device (20) configured to pick up a die (D) from a sheet (63) to which a wafer (W) divided into multiple dies (D) is affixed using a nozzle (24) and mount the die (D) on a target object (S), the die mounting device (20) comprising:
a board conveyance device (21) for loading and fixing the target object (S) at a mounting position,
a tape supply device (28) comprising a reel around which a tape for supplying components to the mounting device (20) is wound;
a head (22) including the nozzle (24) configured to be raised and lowered and to pick up die (D) from the sheet (63) or a component supplied from tape supply device (28);
a peeling device (70) configured to peel the die (D) from the sheet (63) by pushing the die (D) to be picked up by the nozzle (24) from underneath the sheet (63) using a pusher pin (73);
a component camera (25) provided between the board conveyance device (21) and the tape supply device (28) and configured to image a die (D) held by suction nozzle (24) when suction nozzle (24) holding the die (D) passes above component camera (25) and to output the image to a control device (29);
a load measuring section (59) configured to measure a load applied to the nozzle (24) or the pusher pin (73); wherein
the control device (29) is configured to control the head (22) and the peeling device (70) such that the die (D) is picked up by the nozzle (24) by being peeled from the sheet (63) with the pusher pin (73) pushing the die (D) from underneath the sheet (63) in a state with the nozzle (24) contacting the die (D), and determine whether the die (D) has broken based on the load measured by the load measuring section (59) when the die (D) is pushed up by the pusher pin (73); and wherein
the control device (29) is configured to, when determining that the die (D) has broken, control the mounting head (22) to pick up the die (D) using the nozzle (24) and discard the die (D) to a specified discard location remote of the peeling device (70) on a path that avoids going above component camera (25) and target object (S).

2. The die mounting device (20) according to claim 1, wherein
the control device (29) is configured to control the peeling device (70) and the head (22) such that the die (D) is peeled from the sheet (63) by the peeling device (70) and picked up by the nozzle (24) based on the load measured by the load measuring section (59), or control the head (22) such that the die (D) picked up by the nozzle (24) is mounted on the target object based on the load measured by the load measuring section (59).

## Patentansprüche

1. Eine Chip-Montagevorrichtung (20), die konfiguriert ist, einen Chip (D) von einem Blatt (63) aufzunehmen, an dem ein in mehrere Chips (D) unterteilter Wafer (W) unter Verwendung einer Düse (24) befestigt ist, und den Chip (D) an einem Zielobjekt (S) zu montieren, wobei die Chip-Montagevorrichtung (20) umfasst:
eine Plattentransportvorrichtung (21) zum Laden und Fixieren des Zielobjekts (S) an einer Montageposition,
eine Bandzuführvorrichtung (28), die eine Spule umfasst, um die ein Band zum Zuführen von Komponenten zur Montagevorrichtung (20) gewickelt ist;
einen Kopf (22) mit der Düse (24), der konfiguriert ist, angehoben und abgesenkt werden zu können und den Chip (D) von dem Blatt (63) oder einem von der Bandzuführungsvorrichtung (28) zugeführtes Bauteil aufzunehmen;
eine Abziehvorrichtung (70), die konfiguriert ist, den Chip (D) von dem Blatt (63) abzuziehen, indem sie den von der Düse (24) aufzunehmenden Chip (D) mit Hilfe eines Schieberstifts (73) von unterhalb des Blatts (63) schiebt;
eine Bauteilkamera (25), die zwischen der Plattentransportvorrichtung (21) und der Bandzuführvorrichtung (28) angeordnet ist und konfiguriert ist, ein Bild eines von der Düse (24) gehaltenen Stanzstempels (D) abzubilden, wenn die den Stanzstempel (D) haltende Düse (24) oberhalb der Bauteilkamera (25) vorbeiläuft, und das Bild an eine Steuervorrichtung (29) ausgibt;
einen Lastmessabschnitt (59), der konfiguriert ist, eine auf die Düse (24) oder den Schieberstift (73) ausgeübte Last zu messen und wobei
die Steuervorrichtung (29) konfiguriert ist, den Kopf (22) und die Abziehvorrichtung (70) so zu steuern, dass der Chip (D) von der Düse (24) aufgenommen wird, indem er von dem Blatt (63) abgezogen wird, wobei der Druckstift (73) den Chip (D) von unterhalb des Blattes (63) in einem Zustand drückt, in dem die Düse (24) den Chip (D) berührt, und zu bestimmen, ob der Chip (D) gebrochen ist, basierend auf der Last, die von dem Lastmessabschnitt (59) gemessen wird, wenn der Chip (D) von dem Schieberstift (73) nach oben geschoben wird; wobei
die Steuervorrichtung (29) konfiguriert ist, dass sie, wenn sie feststellt, dass der Chip (D) gebrochen ist, den Montagekopf (22) so steuert, dass er den Chip (D) unter Verwendung der Düse (24) aufnimmt und den Chip (D) zu einer spezifizierten Abwurfstelle entfernt von der Abziehvorrichtung (70) auf einem Weg abwirft, der es vermeidet, über die Bauteilkamera (25) und das Zielobjekt (S) zu gehen.

2. Die Chip-Montagevorrichtung (20) gemäß Anspruch 1, wobei
die Steuervorrichtung (29) konfiguriert ist, die Abziehvorrichtung (70) und den Kopf (22) so zu steuern, dass der Chip (D) von dem Blatt (63) durch die Abziehvorrichtung (70) abgezogen und von der Düse (24) auf der Grundlage der von dem Lastmessabschnitt (59) gemessenen Last aufgenommen wird, oder den Kopf (22) so zu steuern, dass der von der Düse (24) aufgenommene Chip (D) auf der Grundlage der von dem Lastmessabschnitt (59) gemessenen Last auf dem Zielobjekt montiert wird.

## Revendications

1. Dispositif de montage de puces électroniques (20) configuré pour saisir à l'aide d'une buse (24) une puce électronique (D) sur une feuille (63), sur laquelle est fixée une tranche (W) divisée en de multiples puces électroniques (D), et pour monter la puce électronique (D) sur un objet cible (S), le dispositif de montage de puces électroniques (20) comprenant :
un dispositif de convoyage de cartes (21) pour charger et fixer l'objet cible (S) à une position de montage,
un dispositif d'approvisionnement de bande (28) comprenant une bobine autour de laquelle est enroulée une bande destinée à approvisionner en composants le dispositif de montage (20) ;
une tête (22) incluant la buse (24), configurée pour être levée et abaissée, et pour saisir la puce électronique (D) sur la feuille (63) ou un composant approvisionné par le dispositif d'approvisionnement de bande (28) ;
un dispositif de pelage (70) configuré pour peler la puce électronique (D) de la feuille (63) en poussant la puce électronique (D) qui doit être saisie par la buse (24) depuis le dessous de la feuille (63) à l'aide d'une broche de poussée (73) ;
une caméra de composant (25) pourvue entre le dispositif de convoyage de cartes (21) et le dispositif d'approvisionnement de bande (28) et configurée pour imager une puce électronique (D) maintenue par la buse d'aspiration (24) quand la buse d'aspiration (24) maintenant la puce électronique (D) passe au-dessus de la caméra de composant (25), et pour transmettre l'image à un dispositif de contrôle (29) ;
une section de mesure de charge (59) configurée pour mesurer une charge appliquée à la buse (24) ou à la broche de poussée ;
dans lequel le dispositif de contrôle (29) est configuré pour contrôler la tête (22) et le dispositif de pelage (70) de telle sorte que la puce électronique (D) soit saisie par la buse (24) tandis qu'elle est pelée de la feuille (63) par la broche de poussée (73), qui pousse la puce électronique (D) depuis le dessous de la feuille (63), dans un état où la buse (24) est en contact avec la puce électronique (D), et pour déterminer si la puce électronique (D) est défectueuse ou non sur la base de la charge mesurée par la section de mesure de charge (59) quand la puce électronique (D) est poussée vers le haut par la broche de poussée (73) ; et
dans lequel le dispositif de contrôle (29) est configuré pour, quand il est déterminé que la puce électronique (D) est défectueuse, contrôler la tête de montage (22) pour saisir la puce électronique (D) à l'aide de la buse (24) et pour éliminer la puce électronique (D) dans un emplacement d'élimination spécifié distant du dispositif de pelage (70) sur un chemin qui évite de passer au-dessus de la caméra de composant (25) et de l'objet cible (S).

2. Dispositif de montage de puces électroniques (20) selon la revendication 1, dans lequel
le dispositif de contrôle (29) est configuré pour contrôler le dispositif de pelage (70) et la tête (22) de telle sorte que la puce électronique (D) soit pelée de la feuille (63) par le dispositif de pelage (70) et saisie par la buse (24) sur la base de la charge mesurée par la section de mesure de charge (59), ou pour contrôler la tête (22) de telle sorte que la puce électronique (D) saisie par la buse (24) soit montée sur l'objet cible sur la base de la charge mesurée par la section de mesure de charge (59).
